# EUROPEAN PATENT APPLICATION

(11) **EP 3 062 341 A2**
(43) Date of publication of application: **31.08.2016**
(21) Application number: 16157345.6
(22) Date of filing: 25.02.2016
(51) Int. Cl.: H01L 23/482, H01L 23/485, H01L 21/60, H01L 25/065, H01L 21/98, H02M 7/5387

(54) **SEMICONDUCTOR DEVICE WITH AN ELECTRODE STRUCTURE COMPRISING AN ALUMINIUM OR ALUMINIUM ALLOY LAYER WITH {110} TEXTURE, METHOD OF MANUFACTURING SAID SEMICONDUCTOR DEVICE AND POWER CONVERSION DEVICE COMPRISING SAID SEMICONDUCTOR DEVICE**

(30) Priority: 26.02.2015 JP 2015036099
(71) Applicant: Hitachi Power Semiconductor Device, Ltd., Hitachi-shi, Ibaraki 319-1221 (JP)
(72) Inventor: FURUKAWA, Tomoyasu, Tokyo, 100-8280 (JP); SHIRAISHI, Masaki, Tokyo, 100-8280 (JP); NAKANO, Hiroshi, Tokyo, 100-8280 (JP); MORITA, Toshiaki, Tokyo, 100-8280 (JP)
(74) Representative: Beetz & Partner mbB

(57) **Abstract**

A semiconductor device (200, 300, 400) includes a semiconductor substrate (108, 208) in which a semiconductor element (150) is formed, an electrode structure (151, 202, 207) provided on a first surface (108d) of the semiconductor substrate (108, 208) to be electrically connected to the semiconductor element (150) and in which a first Al metal layer (105) composed of Al or Al alloy, a Cu diffusion-prevention layer (107) composed of e.g. Ti, TiN, TiW or W, a second Al metal layer (106) composed of Al or Al alloy and a Ni, Cu or Cu alloy layer (104) are formed in this order, and a conductive member (102) which is bonded to the electrode structure (151, 202, 207) via a sintered copper layer (103) disposed on a surface (104a) of the Ni, Cu or Cu alloy layer (104). In this semiconductor device, a crystal plane orientation of Al crystal grains on a surface (106a) of the second Al metal layer (106) is principally on the (110) plane. The semiconductor device (200) may comprise a second electrode structure (152) on the second surface (108e) of the semiconductor substrate (108), also formed of the layers (105), (107), (106) and (104) and bonded to a conductive member (102) via a sintered copper layer (103). Alternatively, the semiconductor device (300, 400) may comprise a plurality of semiconductor elements such as transistors, diodes and resistive elements formed on a semiconductor LSI chip (201, 205, 206) and a plurality of input/output electrode pads (202, 207) each formed of the layers (105), (107), (106) and (104). The LSI chip (201, 205, 206) may be bonded to another semiconductor LSI chip (205, 206), also having electrode pads (202, 207) formed of the layers (105), (107), (106) and (104), and/or to a conductive member (102) via a sintered copper layer (103).

## Description

### CROSS-REFERENCE TO RELATED APPLICATION

This application is based upon and claims priority from the Japanese Patent Application No. 2015-036099, filed on February 26, 2015, the entire contents of which are incorporated herein by reference.

### BACKGROUND OF THE INVENTION

### 1. Field of the Invention

The present invention relates to a semiconductor device, a method of manufacturing the semiconductor device, and a power conversion device.

### 2. Description of the Related Art

Semiconductor devices are employed in a wide range of fields, such as a system LSI (Large Scale Integration), a power conversion device, a control device in a hybrid automobile, and the like. In the semiconductor devices, for example, when electrode terminals of an electronic component and electrode terminals in a circuit pattern on a circuit board are electrically bonded to each other, electrical bonding with "solder" or "solder alloy" containing lead has been the mainstream in the field.

From a standpoint of global environmental conservation, use of lead has been severely limited and thus development to limit the use of lead to make bonding of electrodes and the like with a lead-free material has been carried out. In particular, as for "high temperature solder", an effective material to be substituted therefor has not yet been found. Since it is necessary to use a "lead-free multilevel solder" in the mounting, appearance of a material substituting for the "high temperature solder" has been desired.

From such background, a bonding technology has been proposed in which a composite material composed of metal particles and an organic compound is used as the material substituting for the "high temperature solder" to make bonding of electrodes.

Patent document 1 (Japanese Unexamined Patent Application Publication No.2008-244242) discloses a semiconductor device which is achieved by making bonding in a reducing atmosphere with a bonding material containing particles of copper oxide (CuO) and a reducing agent composed of an organic material, as a bonding technology which allows a good strength of bonding to a Ni or Cu electrode to be obtained. In the bonding technology disclosed in Patent document 1, particles of copper with a particle size of 100 nm or less are generated in a heating and reducing process to allow the particles of copper to be sintered and bonded to each other. The bonding technology using particles of copper oxide (CuO) disclosed in Patent document 1 allows the property of bonding to Ni or Cu to be improved as compared to a conventional nanoparticle bonding technology, and thus can be expected as a bonding technology for a Ni electrode or a Cu electrode. For example, a connection terminal can be electrically connected via a bonding layer composed of a sintered copper layer to a Ni electrode of a power semiconductor chip such as an IGBT (Insulated Gate Bipolar Transistor), a flywheel diode, or the like, employed in an inverter of a power conversion device.

As a method of forming a Ni electrode of a power semiconductor chip, there is known a method of making a Ni layer grow, for example, by an electroless plating process, on the surface of an Al metal layer.

Patent document 2 (Japanese Patent No.4973046) discloses a semiconductor device having a configuration in which a conductive member is bonded via solder to a Ni layer. The semiconductor device disclosed in Patent document 2 is configured so that an Al electrode is formed on the surface of a semiconductor substrate and the Al electrode is divided into a first Al metal layer and a second Al metal layer. Moreover, a heterogeneous material layer is disposed between the first Al metal layer and the second Al metal layer, and when a crystal orientation on the surface of the Al metal layer is principally on (111) plane, a Ni-plated layer to be formed on the Al metal layer is expected to become most homogeneous or dense.

However, according to examination by the present inventors, a stable film formation such that the crystal orientation on the surface of the Al metal layer is principally on the (111) plane in Patent document 2 has proved to be difficult. That is, a stable film formation such that the crystal orientation on the surface of the Al metal layer is principally on the (111) plane cannot be achieved, thus posing problems that thickness and/or density of the Ni-plated layer become non-homogeneous to allow Ni-film defects in the form of pinholes to be generated.

Also, where a connection terminal is electrically connected via a bonding layer composed of a sintered copper layer to a Ni electrode of a power semiconductor chip when Ni-film defects in the form of pinholes exist in the Ni electrode of the power semiconductor chip, copper diffuses into the power semiconductor chip from the bonding layer, thereby posing problems of increase in leak current from the element, deterioration in a withstanding voltage of the element, 1200 V, and fluctuation in characteristics of the element.

### SUMMARY OF THE INVENTION

The present invention has been made in view of the above circumstances, and an object thereof is to provide a semiconductor device, a method of manufacturing the semiconductor device, and a power conversion device that are capable of reducing film defects in a formed electrode film.

In order to solve the above problems, the present invention provides, as one aspect thereof, a semiconductor device including: a semiconductor substrate in which a semiconductor element is formed; an electrode structure of a first semiconductor chip which is provided on a first surface of the semiconductor substrate to be electrically connected to the semiconductor element and in which a first Al metal layer composed of Al or Al alloy, a Cu diffusion-prevention layer, a second Al metal layer composed of Al or Al alloy, and a metal layer are formed in this order; and a conductive member which is bonded to the electrode structure of the first semiconductor chip via a sintered copper layer disposed on a surface of the metal layer in the electrode structure of the first semiconductor chip, wherein a crystal plane orientation of Al crystal grains on a surface of the second Al metal layer is principally on (110) plane.

Moreover, the present invention provides, as another aspect thereof, a method of manufacturing the above semiconductor device, the method including the steps of: preparing the semiconductor substrate in which the semiconductor element is formed; forming the first Al metal layer on the surface of the semiconductor substrate; forming, on a surface of the first Al metal layer, the Cu diffusion-prevention layer which prevents copper in the sintered copper layer from diffusing while securing conductive property of the first Al metal layer; forming, on a surface of the Cu diffusion-prevention layer, the second Al metal layer composed of the same material as the first Al metal layer; forming the metal layer on the second Al metal layer; dividing the semiconductor substrate into chips to form electrode structures of the first semiconductor chip; and bonding the electrode structures of the first semiconductor chip to each other via the sintered copper layer.

Furthermore, the present invention provides, as still another aspect thereof, a power conversion device including: a pair of DC terminals; the same number of AC terminals as the number of phases of AC; and the same number of power conversion units as the number of phases of AC, each power conversion unit including a configuration in which two parallel circuits are series-connected between the pair of DC terminals, each parallel circuit being composed of a switching element and a diode connected in reversely parallel to the switching element, each connection point between the two parallel circuits of the respective power conversion units being connected to each of the AC terminals, wherein each of the switching elements is the semiconductor device described above.

According to the present invention, it is possible to provide a semiconductor device, a method of manufacturing the semiconductor device, and a power conversion device that are capable of reducing film defects in a formed electrode film.

### BRIEF DESCRIPTION OF THE DRAWINGS

FIG.1 is a cross-sectional view of a semiconductor device according to a first embodiment of the present invention.
FIGS.2A, 2B and 2C are diagrams showing each step of a method of manufacturing the semiconductor device according to the first embodiment.
FIGS.3A, 3B and 3C are diagrams showing each step of a method of manufacturing the semiconductor device according to the first embodiment.
FIG.4 is a characteristic diagram representing a relationship between the size of an average crystal grain in a second Al metal layer and scrape-off amount of the second Al metal layer, which is obtained by zincate treatment in electrolytic plating, with respect to the semiconductor device according to the first embodiment.
FIG.5 is a cross-sectional view of a semiconductor device according to a second embodiment of the present invention.
FIG.6 is a configuration diagram of a semiconductor device according to a third embodiment of the present invention.
FIG.7 is a cross-sectional view taken along the line A-A in FIG.6.
FIG.8 is a configuration diagram of a semiconductor device according to a fourth embodiment of the present invention.
FIG.9 is a cross-sectional view taken along the line B-B in FIG.8.
FIG.10 is a circuit diagram of a power conversion device according to a fifth embodiment of the present invention.

### DETAILED DESCRIPTION OF THE PREFERRED EMBODIMENTS

Embodiments of the present invention will be hereinafter described in detail with reference to the drawings.

### (First embodiment)

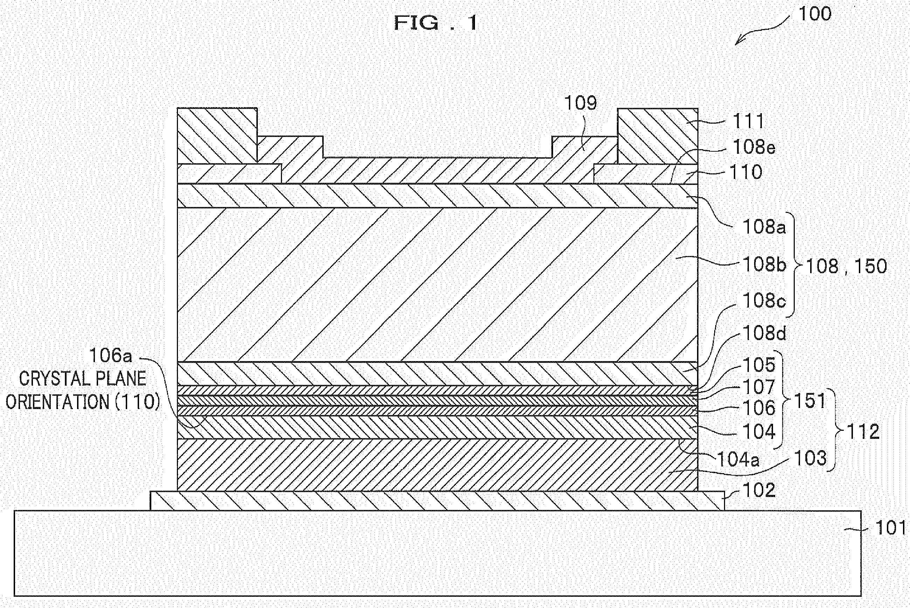

FIG.1 is a cross-sectional view of a semiconductor device according to a first embodiment of the present invention.
FIG.1 illustrates a cross-sectional structure in a case where the semiconductor device according to the present embodiment is applied to a flywheel diode in a power semiconductor chip. Note that, although description will be given of application to a diode using an n-type Si substrate, the manner of application is not limited to this example. The semiconductor device can be applied likewise to a case of using a p-type Si substrate. The semiconductor device can also be applied likewise to an electrode structure of an IGBT which passes an electric current in the vertical direction.

As shown in FIG.1, a semiconductor device 100 includes a semiconductor substrate 108 composed of n-type Si. The semiconductor substrate 108 includes, sequentially from an upper surface thereof, a p-type semiconductor layer 108a, an n⁻ drift layer 108b, and an n⁺-type semiconductor layer 108c composed of a highly concentrated n-type impurity region, which form a semiconductor element 150 composed of semiconductor layers. The semiconductor substrate 108 has a first surface 108d on which an electrode structure 151 of a first semiconductor chip is formed, and a second surface 108e on which an anode electrode 109 is formed.

The semiconductor device 100 includes the semiconductor substrate 108 in which the semiconductor element 150 is formed, the electrode structure 151 of the first semiconductor chip which is provided on the first surface 108d of the n⁺-type semiconductor layer 108c of the semiconductor substrate 108 to be electrically connected to the semiconductor element 150 and in which a first Al metal layer 105 composed of Al or Al alloy, a Cu diffusion-prevention layer 107, a second Al metal layer 106 composed of Al or Al alloy, and a Ni layer 104 (metal layer) are formed in this order, and a conductive member 102 which is bonded to the electrode structure 151 of the first semiconductor chip via a sintered copper layer 103 disposed on a surface 104a of the Ni layer 104.

Specifically, a crystal plane orientation of Al crystal grains on a surface 106a of the second Al metal layer 106 is principally on (110) plane.

Note that the first semiconductor chip is constituted by the semiconductor substrate 108 and the electrode structure 151 of the first semiconductor chip.

The first Al metal layer 105, the Cu diffusion-prevention layer 107, the second Al metal layer 106 and the Ni layer 104 are formed in this order to constitute a cathode electrode 112 on a lower surface of the semiconductor substrate 108. The cathode electrode 112 is bonded via the sintered copper layer 103 to the conductive member 102 on a ceramic insulating substrate 101. The Ni layer 104 is, for example, an electroless Ni plated layer. The Ni layer 104 is a metal layer which forms a connection electrode, and the metal layer may be formed of Cu other than Ni, or a Cu alloy.

The anode electrode 109 on the second surface 108e of the semiconductor substrate 108 has an electrode structure composed of Al or Al alloy. A portion of the anode electrode 109 is in contact with the p-type semiconductor layer 108a of the semiconductor substrate 108 and the other portion thereof is in contact with an insulating oxide film 110. Moreover, a passivation film 111 serving as a surface protection film is formed on the insulating oxide film 110. The passivation film 111 is formed of, for example, polyimide.

Next, description will be given of a method of manufacturing the semiconductor device 100 according to the first embodiment of the present invention.

### [Manufacturing method of semiconductor device 100]

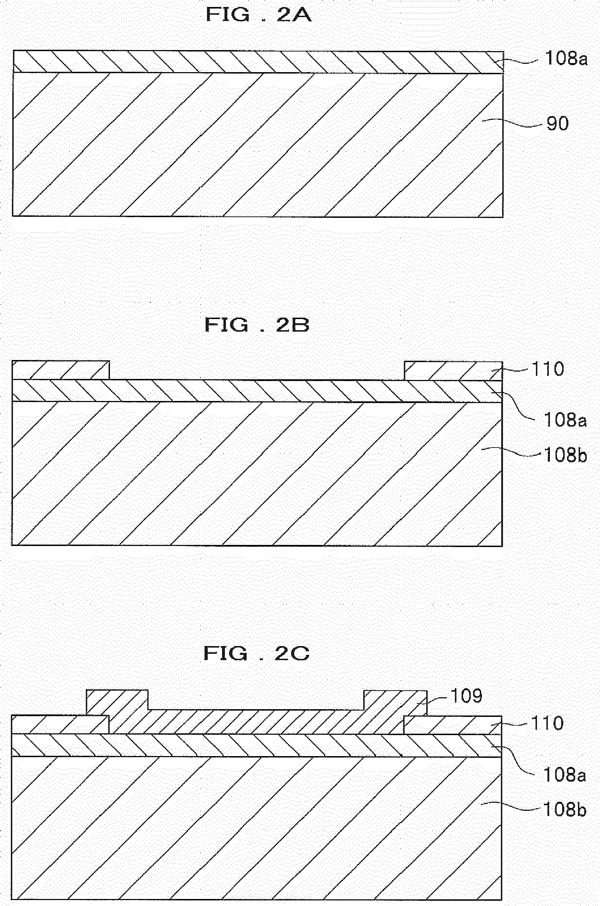

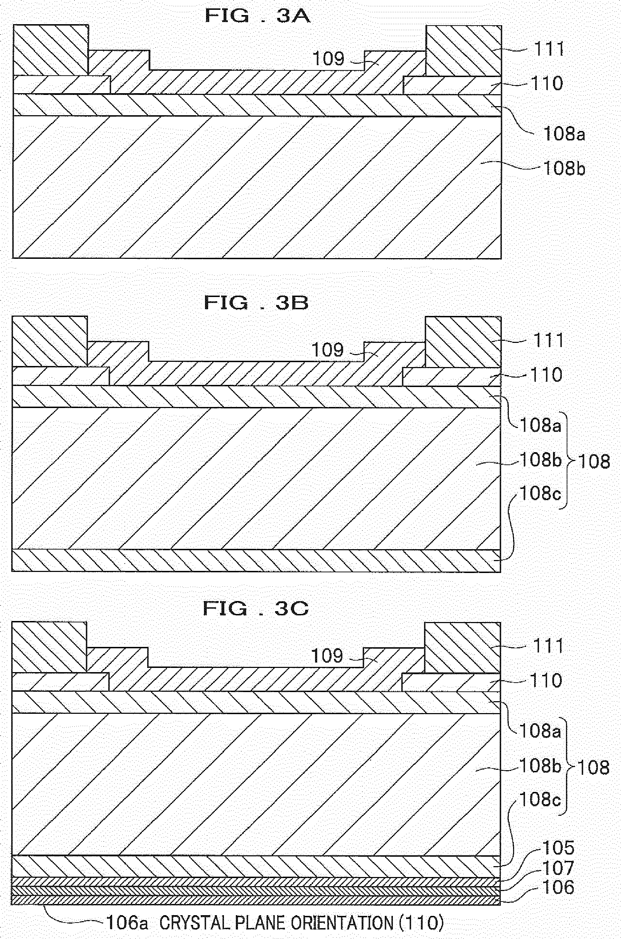

FIGS. 2A to 2C and FIGS. 3A to 3C are diagrams showing each step of the method of manufacturing the semiconductor device 100.

### <Fabrication process of diode (semiconductor element 150)>

FIG.2A is a cross-sectional view after formation of the anode p-type semiconductor region in the present embodiment.

First, a Si wafer 90 is prepared for fabricating the diode. For the Si wafer, a wafer having a specific resistance depending on a withstanding voltage can be used. The specific resistance is, for example, about 55 Ωcm for a diode having a withstanding voltage of 1200 V, and about 250 Ωcm for a diode having a withstanding voltage of 3.3 kV. At this time, the Si wafer 90 serves as an n⁻ layer because the specific resistance is high. In the description below, the Si wafer 90 on which the p-type semiconductor layer 108a is formed is called the n⁻ drift layer 108b.

At first step not shown, an oxide film is formed by thermal oxidation all over the surface of the Si substrate. Then, photolithography process is performed for forming a region where the p-type semiconductor layer 108a is provided. In this photolithography process, a resist material is applied to the surface of the Si substrate, then exposed and developed, thereby forming a resist layer having an opening in a region corresponding to the p-type semiconductor layer 108a. Then, p-type impurities are ion-implanted. Examples of the p-type impurities include boron. Then, the resist layer is removed and annealing treatment for activating the impurities is performed, thereby forming the p-type semiconductor layer 108a as shown in FIG.2A.

FIG.2B is a cross-sectional view after formation of a contact portion in the present embodiment, and FIG.2C is a cross-sectional view after formation of the anode electrode.

Next, an oxide film is formed by thermal oxidation on the Si substrate and the insulating oxide film 110 is then deposited by a CVD (Chemical Vapor Deposition) method, so as to perform photolithography process for forming the contact portion in which the anode electrode 109 (see FIG.2C) is connected with the p-type semiconductor layer 108a. More specifically, a resist material is applied to the Si substrate, exposed and developed, and the insulating oxide film 110 is then etched with the formed resist layer as a mask, thereby forming the contact portion in which the anode electrode 109 is connected with the p-type semiconductor layer 108a, as shown in FIG.2B. Subsequently, the anode electrode 109 composed of Al or Al alloy is film-formed by a sputtering method and the resist layer is then patterned and etched by the photolithography process, thereby forming the anode electrode 109 as shown in FIG.2C.

Then, the surface protection film 111 (see FIG.3A) is formed. This surface protection film 111 can be formed, for example, by applying solution containing a polyimide precursor material and a sensitive material to the entire surface on the side on which the anode electrode 109 is formed, and exposing a termination region to transform the precursor into polyimide.

Next, description will be given of a fabrication process on the lower surface side of the semiconductor substrate 108.

### <Fabrication process on lower surface side>

FIG.3A is a cross-sectional view after formation of the surface protection film 111 in the present embodiment.

First, the lower surface of the n⁻ drift layer 108b is ground to reduce the wafer thickness. The wafer thickness varies depending on a withstanding voltage and is, for example, about 120 µm for a product having a withstanding voltage of 1200 V, and about 400 µm for a product having a withstanding voltage of 3300 V.

Then, ion implantation of n-type impurities is performed on the entire wafer from the lower surface side of the n⁻ drift layer 108b. Examples of the n-type impurities include phosphorus, arsenic, and the like.

Subsequently, laser-annealing treatment for activating the ion-implanted n-type impurities is performed, thereby forming the n⁺-type semiconductor layer 108c as shown in FIG.3B.

Next, description will be given of a fabrication process of the cathode electrode 112 on the lower surface of the semiconductor substrate 108.

### <Fabrication process of cathode electrode 112 on lower surface>

FIG. 3B is a cross-sectional view after formation of the n⁺-type semiconductor layer 108c in the present embodiment.

As shown in FIG.3C, on the n⁺-type semiconductor layer 108c, the metal layers composing the electrode on the lower surface side, i.e., the first Al metal layer 105 composed of, e.g., AlSi alloy and having a thickness of 0. 6 µm, the Cu diffusion-prevention layer 107 composed of, e.g., Ti and having a thickness of 0.2 µm, and the second Al metal layer 106 composed of, e.g., AlSi alloy and having a thickness of 2 µm, are sequentially film-formed by sputtering. At this time, the sputtering is performed under conditions that a crystal plane orientation of Al crystal grains on the second Al metal layer 106 is principally on (110) plane, and a size of an average crystal grain of AlSi is equal to or more than 0.5 µm, thereby forming the first Al metal layer 105, the Cu diffusion-prevention layer 107, and the second Al metal layer 106 as shown in FIG.3C. As to that the size of the average crystal grain of AlSi is equal to or more than 0.5 µm, description thereof will be given later.

The sputtering for the first Al metal layer 105, the Cu diffusion-prevention layer 107, and the second Al metal layer 106 makes it possible to uniform the average crystal grain in the wafer surface under the condition of low-temperature sputtering, and can be preferably performed under the condition of film formation below 200 degrees Celsius.

### <Formation process of Ni layer 104>

FIG.3C is a cross-sectional view after formation of the second Al metal layer 106 in the present embodiment.

As shown in FIG. 1, the Ni layer 104 is formed by an electroless plating process.

Herein, zincate treatment in electroless plating requires the second Al metal layer 106 to be etched. The present inventors have acquired findings that the size of the average crystal grain of AlSi is preferably equal to or more than 0.5 µm with respect to zincate treatment in electrolytic plating.

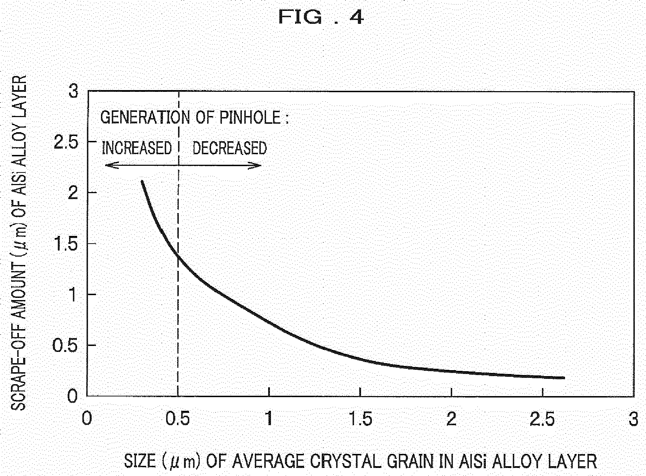

FIG.4 is a characteristic diagram representing a relationship between the size of the average crystal grain in the second Al metal layer 106 and scrape-off amount of the second Al metal layer 106, which is obtained by zincate treatment in electrolytic plating.

As shown in FIG. 4, when the size of the average crystal grain of AlSi is equal to or more than 0.5 µm principally in the (110) plane on the second Al metal layer 106, generation of pinholes is drastically decreased. The sputtering is performed under the condition that the size of the average crystal grain of AlSi is equal to or more than 0.5 µm, thereby suppressing local scrape-off of the AlSi electrode due to zincate treatment in electroless plating, advancing a uniform growth of the Ni layer, and allowing film defects (pinholes) in the Ni electrode film to be reduced. Incidentally, when the size of the average crystal grain of AlSi is equal to or more than 0.5 µm, the scrape-off amount of the AlSi alloy layer becomes substantially constant.

Moreover, the Cu diffusion-prevention layer 107 composed of Ti is provided in the cathode electrode 112 on the lower surface of the semiconductor substrate 108, and accordingly, when the first semiconductor chip is electrically connected to a connection terminal via the bonding layer composed of the sintered copper layer 103, copper is prevented from diffusing into the first semiconductor chip from the bonding layer and thus long-term reliability in the junction is enhanced.

Note that, although Ti is used for the Cu diffusion-prevention layer 107 in the present embodiment, materials such as, e.g., TiN, TiW and W, which make it possible to form a Cu diffusion-prevention layer with its conductive property being secured, can be used in the same manner.

### <Formation of semiconductor device 100>

Next, the wafer formed throughout the steps described above is divided into chips by dicing.

After division into chips, the ceramic insulating substrate 101 on which a wiring layer is formed with the conductive member 102 (e.g., Cu), and a bonding material containing particles of copper oxide (CuO), are prepared. Then, with multistep heating and pressurization in a reducing atmosphere, the cathode electrode 112 on the lower surface of the chip is bonded via the sintered copper layer 103 to the conductive member 102, allowing the semiconductor device 100 to be formed as shown in FIG.1.

The steps described above allow the semiconductor device 100 shown in FIG.1 to be obtained.

As described above, the semiconductor device 100 according to the present embodiment includes the semiconductor substrate 108 in which the semiconductor element 150 is formed, the electrode structure 151 of the first semiconductor chip which is provided on the surface of the n⁺-type semiconductor layer 108c of the semiconductor substrate 108 to be electrically connected to the semiconductor element 150 and in which the first Al metal layer 105 composed of Al or Al alloy, the Cu diffusion-prevention layer 107, the second Al metal layer 106 composed of Al or Al alloy, and the Ni layer 104 are formed in this order, and the conductive member 102 which is bonded to the electrode structure 151 of the first semiconductor chip via the sintered copper layer 103 disposed on the surface of the Ni layer 104. And in this semiconductor device, the crystal plane orientation of Al crystal grains on the surface 106a of the second Al metal layer 106 is principally on (110) plane.

As described above, the sputtering is performed under the condition that the size of the average crystal grain of AlSi is equal to or more than 0.5 µm principally in the (110) plane on the second Al metal layer 106. This allows local scrape-off of the AlSi electrode due to zincate treatment in electroless plating to be suppressed, a uniform growth of the Ni layer to be advanced, and pinholes in the Ni electrode film to be reduced. Accordingly, film defects in the Ni electrode film formed on the surface of the Al electrode by an electroless plating process can be reduced.

In the conventional technique, a stable film formation such that the crystal orientation on the surface of the Al metal layer is principally on (111) plane has been difficult. On the contrary, in the present embodiment, the crystal plane orientation of Al crystal grains on the surface 106a of the second Al metal layer 106 is principally on (110) plane. The structure in which the crystal plane orientation is principally on the (110) plane can be used, thus allowing a stable film formation to be easily achieved.

In the present embodiment, the Cu diffusion-prevention layer 107 is provided in the electrode structure 151 of the first semiconductor chip, thereby preventing copper from diffusing into the first semiconductor chip from the bonding layer composed of the sintered copper layer 103 and making it possible to achieve the semiconductor device 100 which is enhanced in long-term reliability in the junction.

### (Second embodiment)

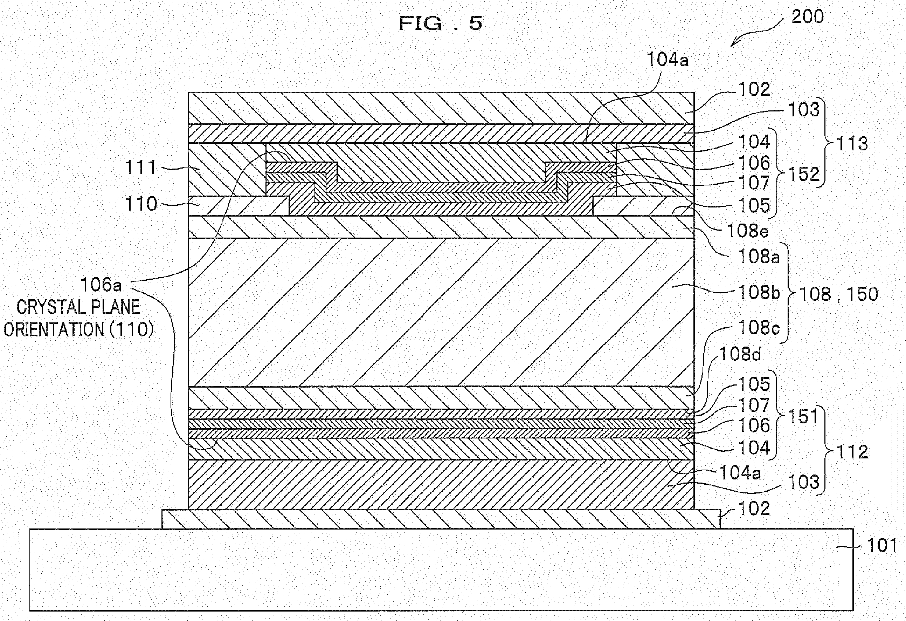

FIG.5 is a cross-sectional view of a semiconductor device 200 according to a second embodiment of the present invention. The same constituent element as in FIG.1 is given the same reference sign and thus description of duplicated parts will be omitted. FIG.5 illustrates an example in a case where the semiconductor device 200 according to the present embodiment is applied to a flywheel diode in a power semiconductor chip. The semiconductor device 200 according to the present embodiment can also be applied in the same manner to an electrode structure of an IGBT which passes an electric current in the vertical direction.

As shown in FIG.5, the semiconductor device 200 further includes an electrode structure 152 of a second semiconductor chip which is provided on the second surface 108e of the semiconductor substrate 108 having the semiconductor element 150 formed therein and in which a first Al metal layer 105 composed of Al or Al alloy, a Cu diffusion-prevention layer 107, a second Al metal layer 106 composed of Al or Al alloy, and a Ni layer 104 (metal layer) are formed in this order, and a conductive member 102 which is bonded to the electrode structure 152 of the second semiconductor chip via a sintered copper layer 103 disposed on a surface 104a of the Ni layer 104 in the electrode structure 152 of the second semiconductor chip. And in this semiconductor device, a crystal plane orientation of Al crystal grains on a surface 106a of the second Al metal layer 106 is principally on (110) plane.

Note that the second semiconductor chip is constituted by the semiconductor substrate 108 and the electrode structure 152 of the second semiconductor chip.

The first Al metal layer 105, the Cu diffusion-prevention layer 107, the second Al metal layer 106 and the Ni layer 104 are formed in this order on the second surface 108e of the semiconductor substrate 108 to constitute a cathode electrode 113 on an upper surface of the semiconductor substrate 108. The Ni layer 104 is bonded via the sintered copper layer 103 to the conductive member 102.

Thus, the semiconductor device 200 according to the present embodiment allows the electrode structure 151 of the first semiconductor chip and the electrode structure 152 of the second semiconductor chip to be formed on both surfaces of the semiconductor substrate 108, and allows the respective conductive members 102 to be bonded via the respective sintered copper layers 103 to the electrode structure 151 of the first semiconductor chip and the electrode structure 152 of the second semiconductor chip.

The semiconductor device 200 according to the present embodiment produces advantageous effects that, in addition to the advantageous effects obtained by the above first embodiment, warpage of the wafer due to stress of the electrode films can be reduced to enhance productivity because similar electrode structures are provided on both surfaces of the semiconductor substrate 108 to form the electrode films having good symmetry with respect to both sides of the wafer.

Where the semiconductor device 200 according to the present embodiment is applied to a power semiconductor module, thermal stress due to a difference in thermal expansion between each member which becomes noticeable in a high temperature environment can be reduced because similar electrode structures are provided on both surfaces of the semiconductor substrate 108 to form the electrode films having good symmetry with respect to both sides of the wafer. Ideally, a coefficient of thermal expansion of the sintered copper layer 103 is matched with that of the conductive member 102, thereby allowing thermal stress generated in the sintered copper layer 103 to be at a minimum and allowing long-term reliability to be enhanced.

### (Third embodiment)

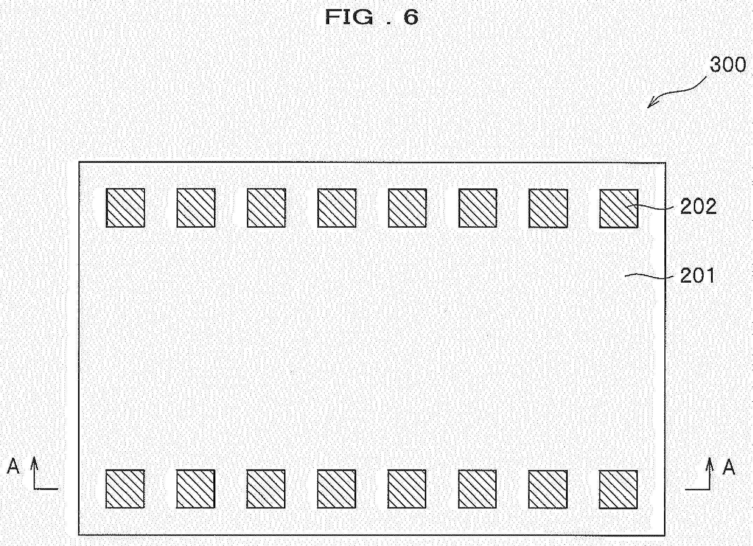

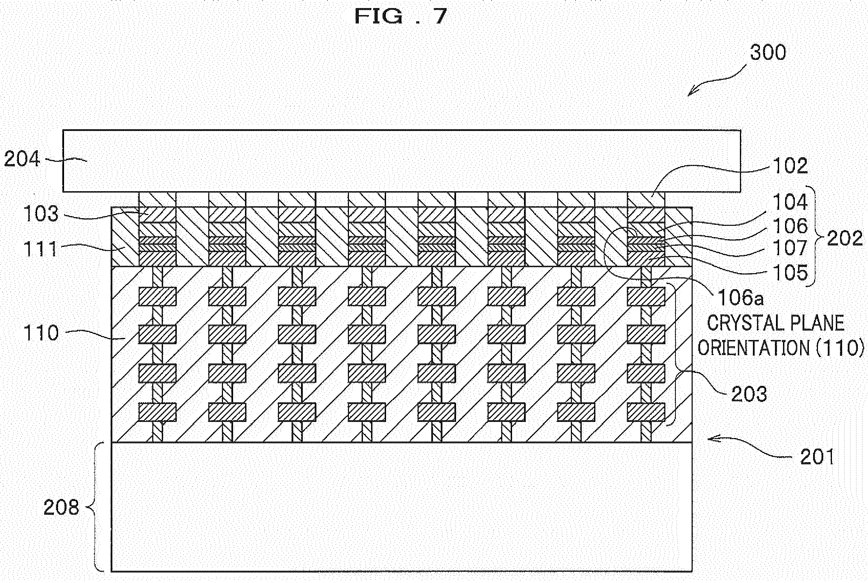

FIG. and FIG.7 are configuration diagrams of a semiconductor device 300 according to a third embodiment of the present invention. FIG.6 is a top view of a semiconductor LSI chip 201, and FIG.7 is a cross-sectional view taken along the line A-A in FIG. 6 in the case of mounting the semiconductor LSI chip 201. The same constituent element as in FIG.1 is given the same reference sign and thus

### description of duplicated parts will be omitted.

As shown in FIG.6, the semiconductor device 300 includes a plurality of semiconductor elements such as transistors, diodes, and resistive elements formed on the semiconductor LSI chip 201, and input/output electrode pads 202 for use in controlling the semiconductor elements, disposed on the semiconductor LSI chip 201.

As shown in FIG.7, the semiconductor device 300 includes a semiconductor substrate 208 (see FIG.7) of the semiconductor LSI chip 201, and a plurality of input/output electrode pads 202 connected via a multi-layer wiring 203 to a plurality of electrodes of the semiconductor LSI chip 201.

The semiconductor LSI chip 201 includes the plurality of semiconductor elements (not shown) such as transistors, diodes and resistive elements formed on the semiconductor substrate 208. Wirings for the electrodes and the like in the semiconductor elements are electrically connected via the multi-layer wiring 203 formed in the insulating oxide film 110 to the input/output electrode pads 202. The semiconductor elements in the semiconductor LSI chip 201 are connected via the multi-layer wiring 203 and the input/output electrode pads 202 to the conductive members 102.

The input/output electrode pads 202 each have the same structure as the electrode structure 151 of the first semiconductor chip of the semiconductor device 100 in FIG.1. More specifically, as shown in FIG.7, the input/output electrode pads 202 are constituted by a semiconductor chip which is provided on the end surface of the multi-layer wiring 203 exposed from the insulating oxide film 110 to be electrically connected to the multi-layer wiring 203 and in which the first Al metal layer 105 composed of Al or Al alloy, the Cu diffusion-prevention layer 107, the second Al metal layer 106 composed of Al or Al alloy, and the Ni layer 104 are formed in this order. And in this semiconductor chip, the crystal plane orientation of Al crystal grains on the surface 106a of the second Al metal layer 106 is principally on (110) plane. The Ni layer 104 of the semiconductor chip constituting the input/output electrode pads 202 is bonded via the sintered copper layer 103 to the conductive member 102 on a substrate 204.

The semiconductor device 300 according to the present embodiment produces advantageous effects that it is good for the environment because solder is not used (i.e., lead-free) in bonding of the input/output electrode pads 202 to the semiconductor LSI chip 201. Moreover, since thermal stress due to a difference in thermal expansion between each member which becomes noticeable in a high temperature environment can be reduced, the semiconductor device 300 which is allowed to be installed in a place in a high temperature environment can be achieved.

### (Fourth embodiment)

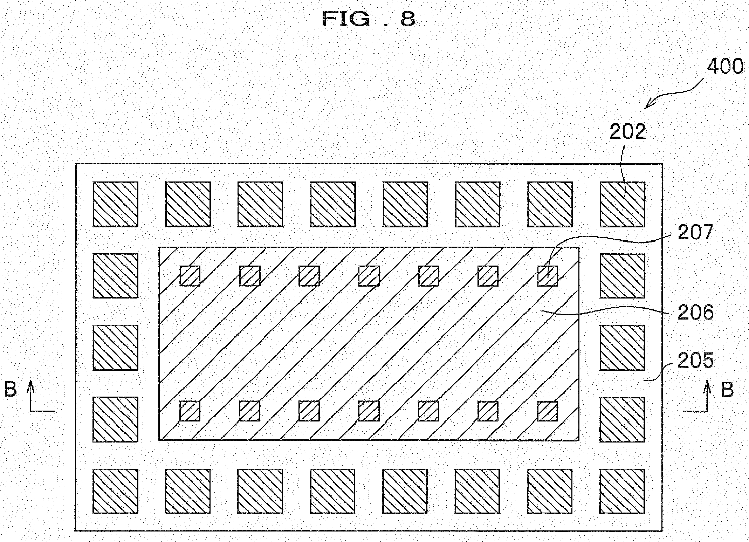

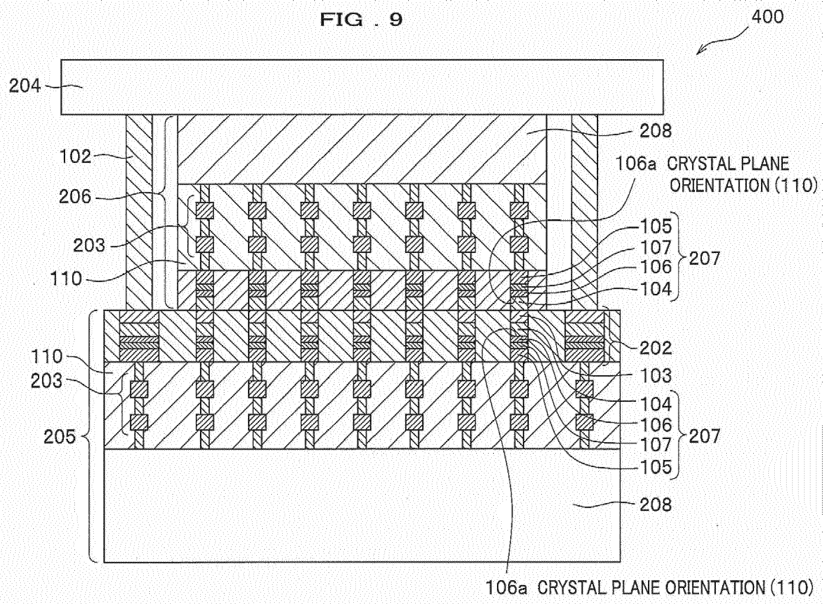

FIG. and FIG. 9 are configuration diagrams of a semiconductor device 400 according to a fourth embodiment of the present invention. FIG.8 is a top view of semiconductor LSI chips 205, 206, and FIG.9 is a cross-sectional view taken along the line B-B in FIG.8 in the case of mounting the semiconductor LSI chips 205, 206. The same constituent element as in FIG.6 and FIG. 7 is given the same reference sign and thus description of duplicated parts will be omitted.

As shown in FIG.8, the semiconductor device 400 has a stacked structure of the first semiconductor LSI chip 205 and the second semiconductor LSI chip 206.

As shown in FIG.9, the semiconductor device 400 includes the first semiconductor LSI chip 205, the second semiconductor LSI chip 206, the plurality of input/output electrode pads 202 connected via the multi-layer wiring 203 to a plurality of electrodes of the first semiconductor LSI chip 205, and inter-chip connection electrode pads 207 which electrically connect the first semiconductor LSI chip 205 with the second semiconductor LSI chip 206.

A plurality of semiconductor elements (not shown) such as transistors, diodes and resistive elements are formed on substrates of the first semiconductor LSI chip 205 and the second semiconductor LSI chip 206, respectively. The input/output electrode pads 202 are disposed for controlling the first semiconductor LSI chip 205 and the second semiconductor LSI chip 206, respectively.

The inter-chip connection electrode pads 207 each have the same structure as the input/output electrode pads 202 of the semiconductor device 300 in FIG.6 and FIG.7 described above. More specifically, the inter-chip connection electrode pads 207 are constituted by a semiconductor chip which is provided on the end surface of the multi-layer wiring 203 exposed from the insulating oxide film 110 to be electrically connected to the multi-layer wiring 203 and in which the first Al metal layer 105 composed of Al or Al alloy, the Cu diffusion-prevention layer 107, the second Al metal layer 106 composed of Al or Al alloy, and the Ni layer 104 are formed in this order. And in the respective semiconductor chips, the crystal plane orientation of Al crystal grains on the surface 106a of the second Al metal layer 106 is principally on (110) plane. The sintered copper layer 103 is formed on the Ni layer 104 of the semiconductor chip on one side constituting the inter-chip connection electrode pads 207, and the first semiconductor LSI chip 205 and the second semiconductor LSI chip 206 are bonded via the sintered copper layer 103 to each other.

The semiconductor device 400 according to the present embodiment produces advantageous effects that it is good for the environment because solder is not used (i.e., lead-free) in further bonding of the inter-chip connection electrode pads 207. Moreover, since thermal stress due to a difference in thermal expansion between each member which becomes noticeable in a high temperature environment can be reduced, the semiconductor device 400 which is allowed to be installed in a place in a high temperature environment can be achieved.

Furthermore, the present embodiment allows a plurality of semiconductor chips to be stacked, thus enabling downsizing of the package.

### (Fifth embodiment)

Description will be given of a fifth embodiment in which the semiconductor device according to the present invention is applied to a power conversion device.

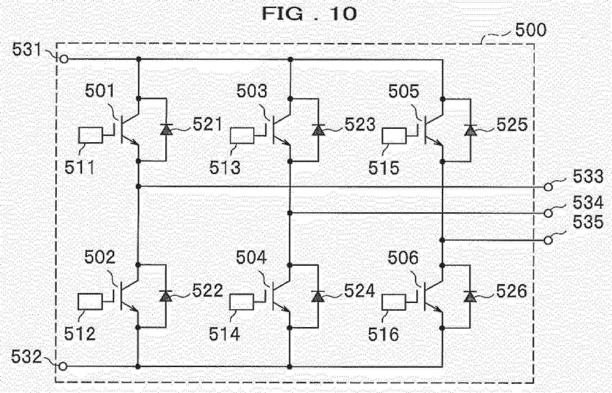

FIG.10 is a circuit diagram showing a power conversion device 500 employing the semiconductor device 100 according to the first embodiment. FIG.10 represents a relation of connection between an example of circuit configuration of the power conversion device 500 according to the present embodiment, and a direct current (DC) power supply and a three-phase alternating current (AC) motor (AC load).

The power conversion device 500 according to the present embodiment uses the semiconductor device 100 according to the first embodiment as power switching elements 501 to 506. Each of the power switching elements 501 to 506 is, for example, an IGBT.

As shown in FIG.10, the power conversion device 500 according to the fifth embodiment includes a P terminal 531 and an N terminal 532 which are a pair of DC terminals, and a U terminal 533, a V terminal 534 and a W terminal 535 which are the same number of AC terminals as the number of phases of AC output.

Also, provided is a switching leg which is constituted by a pair of series-connected power switching elements 501 and 502 and provides an output to the series connection point connected to the U terminal 533. Moreover, provided is a switching leg having the same configuration as the above, which is constituted by a pair of series-connected power switching elements 503 and 504 and provides an output to the series connection point connected to the V terminal 534. Furthermore, provided is a switching leg having the same configuration as the above, which is constituted by a pair of series-connected power switching elements 505 and 506 and provides an output to the series connection point connected to the W terminal 535.

The switching legs of three phases composed of the power switching elements 501 to 506 are connected between the DC terminals of the P terminal 531 and the N terminal 532, and are supplied thereto DC power from a DC power supply not shown. The U terminal 533, the V terminal 534 and the W terminal 535 which are three-phase AC terminals of the power conversion device 500 are connected to the three-phase AC motor not shown, as a three-phase AC power supply.

Diodes 521 to 526 are connected in reversely parallel to the power switching elements 501 to 506, respectively. Gate circuits 511 to 516 are connected to input terminals of respective gates of the power switching elements 501 to 506 each composed of an IGBT. Note that the gate circuits 511 to 516 are comprehensively controlled by a comprehensive control circuit (not shown).

The gate circuits 511 to 516 allow the power switching elements 501 to 506 to be controlled properly and comprehensively, thereby converting the DC power from the DC power supply into a three-phase AC power to output it to the U terminal 533, the V terminal 534 and the W terminal 535.

The semiconductor device according to each of the embodiments described above can be applied to the power conversion device 500, thereby allowing long-term reliability of the power conversion device 500 to be enhanced. Also, the power conversion device 500 produces advantageous effects that it is good for the environment because solder is not used (i.e., lead-free). Moreover, the power conversion device 500 makes it possible to be installed in a place in a high temperature environment and to secure the long-term reliability without a dedicated cooler.

The present invention pertains to a bonding layer in an electrical junction in an electronic component (e.g., a junction between a semiconductor element and a circuit member), and can be preferably applied to, especially, a semiconductor device having a bonding layer bonded using a bonding material containing particles of copper oxide as chief material.

Note that in the present embodiment, description has been given of the case of application to an inverter, as the example of application to a power conversion device of the semiconductor device according to the present invention, but the example is not limited to the inverter. The semiconductor device can also be applied to other power conversion devices such as a DC-DC converter and an AC-DC converter.

### (Other embodiments)

Although the embodiments of the present invention have been described above in detail with reference to the drawings, the present invention is not limited to the embodiments, but may be appropriately modified or altered in process, manufacturing and design within the scope without departing from the gist of the present invention, as follows.

For example, the present invention holds true for not only a configuration in which a first conductivity type of a semiconductor element is an n-type and a second conductivity type is a p-type, but also a configuration in which the first conductivity type is a p-type and the second conductivity type is an n-type.

Moreover, the present invention is not limited to application to a flywheel diode or an IGBT in a power semiconductor chip, but can also be applied to any semiconductor device as long as it is a semiconductor device in which a crystal plane orientation of Al crystal grains on the surface of the Al metal layer 106 is principally on (110) plane.

Furthermore, a part of the configuration in one embodiment can be substituted with the configuration in another embodiment, and the configuration in one embodiment can also be added to the configuration in another embodiment.

In addition, with respect to a part of the configuration in each of the above embodiments, addition thereto or substitution therewith of another configuration, or deletion thereof can be made. Moreover, as for electric wirings, only what is considered to be necessary for description is shown, and all of the electric wirings required in a product are not necessarily shown.

### [Description of Reference Signs]

90: Si wafer; 91: Anode p-type semiconductor layer; 92: Cathode n⁺ layer; 100, 200, 300, 400: Semiconductor device; 101: Ceramic substrate; 102: Conductive member; 103: Sintered copper layer; 104: Ni layer (Metal layer); 104a: Surface of Ni layer; 105: First Al metal layer; 106: Second Al metal layer; 106a: Surface of second Al metal layer; 107: Cu diffusion-prevention layer; 108: Semiconductor substrate; 108a: p-type semiconductor layer; 108b: n⁻ drift layer; 108c: n⁺-type semiconductor layer; 108d: First surface of semiconductor substrate; 108e: Second surface of semiconductor substrate; 109: Anode electrode; 110: Insulating oxide film; 111: Passivation film; 112: Cathode electrode; 113, 119, 403: Insulating film; 150: Semiconductor element; 151: Electrode structure of first semiconductor chip; 152: Electrode structure of second semiconductor chip; 201: Semiconductor LSI chip; 202: Input/output electrode pad; 203: Multi-layer wiring; 204: Substrate; 205: First semiconductor LSI chip; 206: Second semiconductor LSI chip; 207: Inter-chip connection electrode pad; 500: Power conversion device; 501~506: Power switching element; 521~526: Diode; 511~516: Gate circuit

## Claims

1. A semiconductor device (100) comprising:
a semiconductor substrate (108) in which a semiconductor element is formed;
an electrode structure (151) of a first semiconductor chip (150) which is provided on a first surface (108d) of the semiconductor substrate (108) to be electrically connected to the semiconductor element (150) and in which a first Al metal layer (105) composed of Al or Al alloy, a Cu diffusion-prevention layer (107), a second Al metal layer (106) composed of Al or Al alloy, and a metal layer (104) are formed in this order; and
a conductive member (102) which is bonded to the electrode structure (151) of the first semiconductor chip via a sintered copper layer (103) disposed on a surface (104a) of the metal layer (104) in the electrode structure (151) of the first semiconductor chip (150), wherein
a crystal plane orientation of Al crystal grains on a surface (106a) of the second Al metal layer (106) is principally on (110) plane.

2. The semiconductor device (200) according to claim 1, further comprising:
an electrode structure (152) of a second semiconductor chip (150) which is provided on a second surface (108e) of the semiconductor substrate (108) and in which a first Al metal layer (105) composed of Al or Al alloy, a Cu diffusion-prevention layer (107), a second Al metal layer (106) composed of Al or Al alloy, and a metal layer (104) are formed in this order; and
a conductive member (102) which is bonded to the electrode structure (152) of the second semiconductor chip via a sintered copper layer (103) disposed on a surface (104a) of the metal layer (104) in the electrode structure (152) of the second semiconductor chip (150), wherein
a crystal plane orientation of Al crystal grains on a surface (106a) of the second Al metal layer (106) is principally on (110) plane.

3. A semiconductor device (300) comprising:
a plurality of elements formed in a semiconductor substrate (208); and a connection electrode pad (202) electrically connected to each of the elements,
the connection electrode pad (202) including:
an electrode structure (151) of a first semiconductor chip (150) which is provided on a surface (108d) of the semiconductor substrate (108) having the elements formed therein to be electrically connected to the elements and in which a first Al metal layer (105) composed of Al or Al alloy, a Cu diffusion-prevention layer (107), a second Al metal layer (106) composed of Al or Al alloy, and a metal layer (104) are formed in this order; and
a conductive member (102) which is bonded to the electrode structure (151) of the first semiconductor chip (150) via a sintered copper layer (103) disposed on a surface of the metal layer (104), wherein
a crystal plane orientation of Al crystal grains on a surface (106a) of the second Al metal layer (106) is principally on (110) plane.

4. The semiconductor device (100, 200, 300) according to any one of claim 1 to claim 3, wherein a size of an average crystal grain in the second Al metal layer (106) is equal to or more than 0.5 µm.

5. A method of manufacturing the semiconductor device (100) according to claim 1, the method comprising the steps of:
preparing the semiconductor substrate (108) in which the semiconductor element (150) is formed;
forming the first Al metal layer (105) on the surface of the semiconductor substrate (108);
forming, on a surface of the first Al metal layer (105), the Cu diffusion-prevention layer (107) which prevents copper in the sintered copper layer (103) from diffusing while securing conductive property of the first Al metal layer (105);
forming, on a surface of the Cu diffusion-prevention layer (107), the second Al metal layer (106) composed of the same material as the first Al metal layer (105);
forming the metal layer (104) on the second Al metal layer (106) ;
dividing the semiconductor substrate (108) into chips to form electrode structures (151) of the first semiconductor chip (150); and
bonding the electrode structures (151) of the first semiconductor chip (150) to each other via the sintered copper layer (103).

6. The method of manufacturing the semiconductor device (100), according to claim 5, wherein in the step of forming the second Al metal layer (106), a size of an average crystal grain in the second Al metal layer (106) is equal to or more than 0.5 um.

7. A power conversion device (500) comprising:
a pair of DC terminals (531, 532);
the same number of AC terminals (533, 534, 535) as the number of phases of AC; and
the same number of power conversion units as the number of phases of AC, each power conversion unit including a configuration in which two parallel circuits are series-connected between the pair of DC terminals (531, 532), each parallel circuit being composed of a switching element (501-506) and a diode connected in reversely parallel to the switching element (501-506), each connection point between the two parallel circuits of the respective power conversion units being connected to each of the AC terminals, wherein
each of the switching elements (501-506) is the semiconductor device according to any one of claim 1 to claim 4.
